(19) Europäisches Patentamt
European Patent Office
Office européen des brevets

(11) **EP 3 361 836 B1**

(12) **EUROPÄISCHE PATENTSCHRIFT**

(45) Veröffentlichungstag und Bekanntmachung des Hinweises auf die Patenterteilung:
**17.06.2020 Patentblatt 2020/25**

(51) Int Cl.:
*H05K 1/02* (2006.01)     *H02M 7/00* (2006.01)

(21) Anmeldenummer: **17155207.8**

(22) Anmeldetag: **08.02.2017**

(54) **NIEDERINDUKTIVE HALBBRÜCKENANORDNUNG**

LOW INDUCTANCE HALF-BRIDGE CONFIGURATION

SYSTÈME DE DEMI-PONT À FAIBLE INDUCTANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.08.2018 Patentblatt 2018/33**

(73) Patentinhaber: **Siemens Aktiengesellschaft 80333 München (DE)**

(72) Erfinder:
• **Fürst, Johannes**
**92348 Stöckelsberg (DE)**
• **Tannhäuser, Marvin**
**91096 Möhrendorf (DE)**

(56) Entgegenhaltungen:
**EP-A1- 0 400 885      US-A- 5 036 160**
**US-A- 5 357 050       US-A1- 2014 183 550**

EP 3 361 836 B1

**Beschreibung**

Die vorliegende Erfindung betrifft eine Halbbrückenanordnung für einen Umrichter mit zwei Schaltelementen, einer Kondensatoreinrichtung und einer Leiterplatte, mit der die Schaltelemente und die Kondensatoreinrichtung zu einer Halbbrücke zusammengeschaltet sind. Darüber hinaus betrifft die vorliegende Erfindung einen Umrichter mit einer solchen Halbbrückenanordnung.

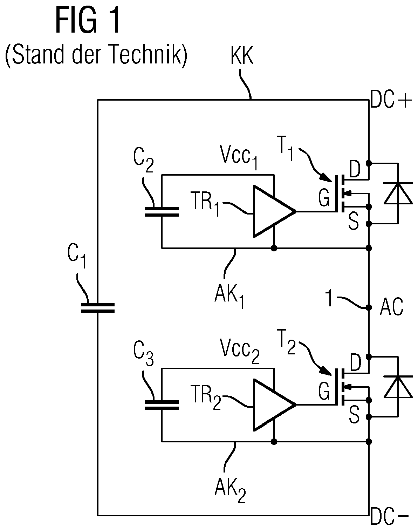

Eine Halbbrücke stellt einen Grundbaustein in der Leistungselektronik dar. Sie wird beispielsweise in den meisten Aufwärts-, Abwärts- sowie Strom- und Spannungswandler-Topologien eingesetzt. In FIG 1 ist ein Schaltplan einer Halbbrückenanordnung mit Ansteuerung gemäß dem Stand der Technik dargestellt. Die Halbbrückenanordnung weist zwei Schaltelemente $T_1$ und $T_2$ auf, die beide als MOSFET mit paralleler Freilaufdiode realisiert sein können. Beide Schaltelemente sind an einem Knotenpunkt 1 miteinander verbunden, an dem üblicherweise die Ausgangsspannung (in der Regel eine Wechselspannung AC) anliegt. In dem vorliegenden Beispiel ist Source S des ersten Schaltelements $T_1$ mit Drain D des zweiten Schaltelements $T_2$ über den Knotenpunkt 1 verbunden. Drain D des ersten Schaltelements $T_1$ befindet sich üblicherweise auf dem positiven Gleichspannungspotenzial DC+ und ist mit einem Pol eines Zwischenkreiskondensators $C_1$ verbunden. Ebenso liegt in dem Beispiel Source S des zweiten Schaltelements $T_2$ an einem negativen Gleichspannungspotenzial DC- und ist mit dem anderen Pol des Zwischenkreiskondensators $C_1$ verbunden.

Gate G des ersten Schaltelements $T_1$ ist mit dem Ausgang eines ersten Treibers $TR_1$ verbunden. An den Versorgungsanschlüssen des ersten Treibers $TR_1$ ist ein Kondensator $C_2$ angeschlossen, der eine erste Versorgungsspannung $Vcc_1$ liefert. Der erste Treiber $TR_1$ bezieht sein Bezugspotenzial von Source S von $T_1$.

Ähnlich ist das zweite Schaltelement $T_2$ mit einem zweiten Treiber $TR_2$ beschaltet. Dessen Ausgang ist mit Gate G des Transistors des zweiten Schaltelements $T_2$ verbunden. Die Versorgungsanschlüsse des Treibers $TR_2$ sind an einen Kondensator $C_3$, welcher eine Versorgungsspannung $Vcc_2$ liefert. Bezugspotenzial für den zweiten Treiber $TR_2$ ist wiederum Source S des zweiten Schaltelements $T_2$.

Für das Schaltverhalten der Halbbrücke ist die parasitäre Induktivität im Kommutierungskreis von Bedeutung. Der Kommutierungskreis ist dabei der Stromkreis, in dem sich bei einem Schaltvorgang der Strom ändert. Dieser Kommutierungskreis KK ist in FIG 1 gestrichelt dargestellt und verläuft durch die Schaltelemente $T_1$, $T_2$ und $C_1$. Des Weiteren entstehen parasitäre Induktivitäten durch einen ersten Ansteuerkreis AK1 an dem ersten Treiber $TR_1$ und einem zweiten Ansteuerkreis AK2 an dem zweiten Treiber $TR_2$. Die jeweiligen Ansteuerkreise AK1 und AK2 verlaufen über Source S und Gate G zum Ausgang des jeweiligen Treibers $TR_1$ bzw. $TR_2$, über den jeweiligen Versorgungsanschluss zum jeweiligen Kondensator $C_2$ bzw. $C_3$ zurück zu Source S.

In der Leistungselektronik gibt es einen Trend, der zu höheren Schaltfrequenzen führt. Dadurch können passive Komponenten (Induktivitäten und Kapazitäten) in vielen Schaltungen verkleinert werden. Dabei entstehen jedoch höhere Schaltverluste (gerade bei "hartem" Schalten, wenn der Strom oder die Spannung nicht Null sind) in den Komponenten, da mit steigender Frequenz mehr Schalthandlungen stattfinden. Die Schaltverluste sind proportional zum Schaltstrom, zur Schaltspannung und zur Schaltzeit. Bei gleicher Anforderung (Strom und Spannung sind fest) an das System können diese durch schnellere Schaltflanken reduziert werden. Die schnelleren Anstiegszeiten bzw. Abfallzeiten von Strom und Spannung rufen Überspannungen und eine zusätzliche Belastung der Störfestigkeit in der Schaltung hervor. Den größten Einfluss haben hier die Streuinduktivitäten bzw. parasitären Induktivitäten im Kommutierungskreis KK und in den Ansteuerkreisen $AK_1$ und $AK_2$ gemäß FIG 1.

Gerade bei höheren Leistungen (höhere Ströme) werden sogenannte Hoch-Kupfer-Leiterplatten verwendet, bei denen die Schichtdicke des Kupfers verglichen mit üblicher Bauweise deutlich erhöht ist. Dort werden aufgrund der hohen Kupferquerschnitte und der üblichen Rampen an den Leiterbahnrändern die Distanzen der Komponenten und somit die Induktivitäten der Strompfade größer. Somit ergeben sich konträre Zielsetzungen bei hohen Leistungen und bei hohen Frequenzen.

Darüber hinaus entstehen bei den Leistungshalbleitern Schalt- und Durchlassverluste in Form von Wärme. Diese Wärme gilt es abzuführen, um die Halbleiter zu entwärmen und sie somit stärker ausnutzen zu können.

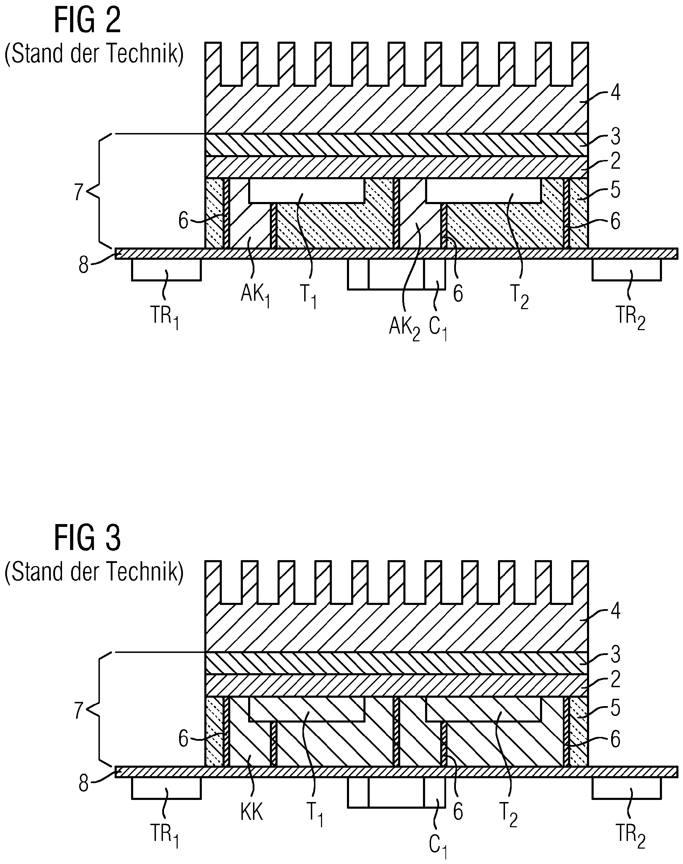

Die genannten Probleme werden in verschiedenen Ansätzen minimiert. Meist wird jedoch jedes Problem einzeln angegangen, sodass sie untereinander konträr sind. Beispielsweise werden zur thermischen Entwärmung sogenannte Module verwendet, wie sie in den FIG 2 und 3 dargestellt sind. Dort sind die Leistungshalbleiter bzw. Schaltelemente $T_1$ und $T_2$ auf ein DCB-Substrat 2 (Direct Copper Bonding) aufgebracht. Das DCB-Substrat 2 selbst wird meist auf einer Aluminium-Bodenplatte 3 fixiert. An der gegenüberliegenden Seite der Aluminium-Bodenplatte 3 ist ein Kühlkörper 4 angeordnet. Die Schaltelemente $T_1$ und $T_2$ sind in einen Isolator 5 eingegossen, durch welchen Verbinder 6 ragen. Ein Modul 7 wird also durch die Aluminium-Bodenplatte 3, das DCB-Substrat 2 und die IsolatorSchicht 5 mit den eingegossenen Schaltelementen $T_1$ und $T_2$ sowie den Verbindern 6 gebildet. Auf der dem Kühlkörper 4 gegenüberliegenden Seite ist das Modul 7 auf einer Leiterplatte 8 befestigt. Die Verbinder 6 stellen dabei die elektrischen Verbindungen von den Schaltelementen $T_1$ und $T_2$ zu der Leiterplatte 8 dar. An der gegenüberliegenden Seite der Leiterplatte 8 können der Zwischenkreiskondensator $C_1$ sowie die Treiber $TR_1$ und $TR_2$ angeordnet sein.

In FIG 2 ist angedeutet, dass sich die Ansteuerkreise AK$_1$ und AK$_2$ im Wesentlichen zwischen innenliegenden Verbindern 6 sowie dem DCB-Substrat 2 und der Leiterplatte 8 ergeben, während sich gemäß FIG 3 der Kommutierungskreis KK zwischen den außenliegenden Verbindern 6 sowie dem DCB-Substrat 2 und der Leiterplatte 8 ergibt. Dabei ist es nicht ohne weiteres möglich, die Streuinduktivitäten der Ansteuerkreise AK$_1$, AK$_2$ sowie des Kommutierungskreis KK zu optimieren, da die Induktivitäten vom Modul 7 dominiert werden. Aufgrund dessen sind diese Aufbauten in der Regel nicht für höhere Schaltfrequenzen geeignet.

Ein weiterer Ansatz ist der Aufbau mit diskreten Bauelementen wie beispielsweise THT-Komponenten (Through-Hole-Technology) und SMD-Komponenten (Surface Mounted Device). Bei THT-Halbleitern sind ähnlich wie bei dem Modulaufbau die Möglichkeiten zur niederinduktiven Anbindung nur begrenzt vorhanden. Auch bei dieser Aufbauart kann eine Anbindung an einen Kühlkörper vorgesehen sein. Hohe Frequenzen werden damit aber nur selten realisiert, weshalb hier nicht weiter drauf eingegangen wird.

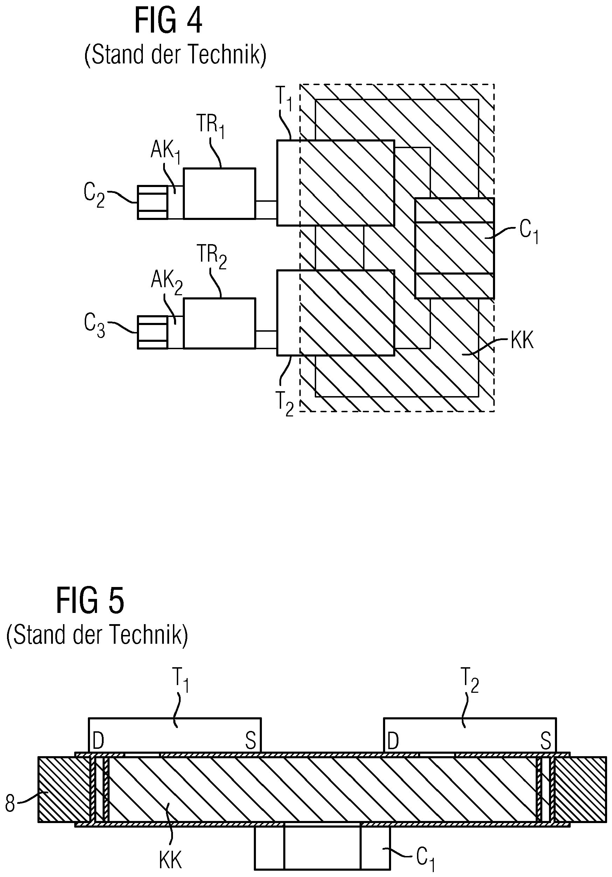

Der SMD-Aufbau auf einer Leiterplatte liefert hier mehr Optimierungspotenzial in Bezug auf höhere Frequenzen. Nachfolgend werden im Zusammenhang mit FIG 4 und FIG 5 zwei häufig verwendete Aufbauarten gezeigt, nämlich eine ein- und eine zweiseitige Bestückung. In FIG 4 ist die einseitig bestückte Variante dargestellt. Hier sind alle Bauteile T$_1$, T$_2$, TR$_1$, TR$_2$, C$_1$, C$_2$ und C$_3$ auf einer Seite einer Platine (nicht dargestellt) angeordnet. Die Ansteuerkreise AK$_1$, AK$_2$ und der Kommutierungskreis KK befinden sich in einer Ebene. Das Optimierungsmaximum für die Streuinduktivität liegt hier bei der Größe der diskreten Bauelemente. Eine Entwärmung der Leistungselektronik ist bei dieser Variante nur schwer möglich.

Die beidseitige Variante der Bestückung gemäß FIG 5 nutzt meist die gleiche Ansteuerung wie in FIG 4 und unterscheidet sich vor allem dadurch, dass eine der drei Hauptkomponenten T$_1$, T$_2$ oder C$_1$ auf der Rückseite der Platine 8 liegt. Der Kommutierungskreis KK ist, wie in FIG 5 zu erkennen ist, abhängig von der Dicke der Platine 8 (z.B. 1,6 mm). Aber auch bei diesem Aufbau ist besonders die Entwärmung des High-Side-Schalter T$_1$ schwierig, da die meisten diskreten Leistungshalbleiter ihr thermisches Pad zum Entwärmen auf Source-Potenzial beziehen und dieses aus Gründen der Störfestigkeit möglichst klein gehalten werden sollte.

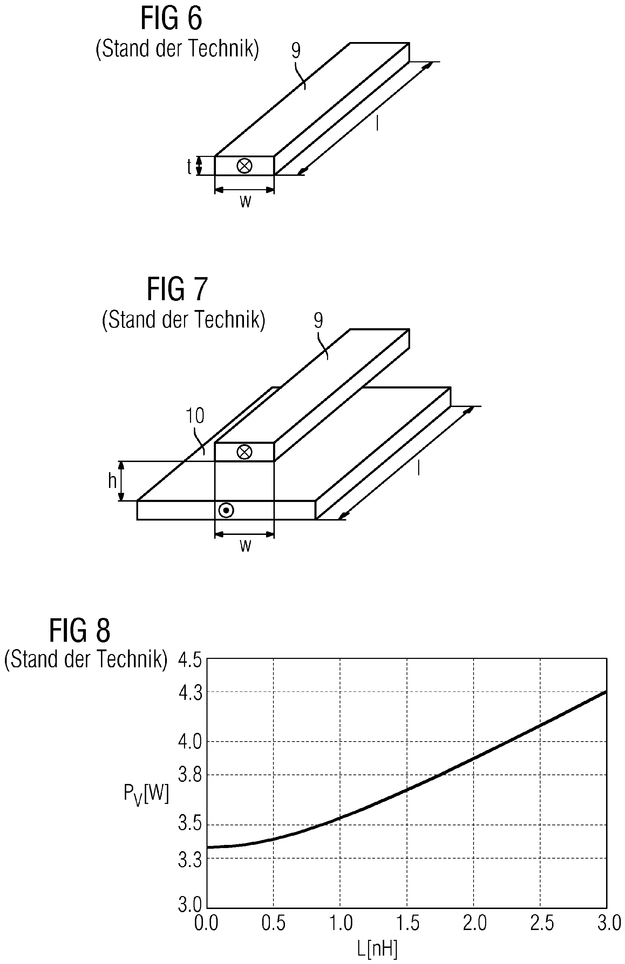

Etwaige Streuinduktivitäten L können mit Hilfe der untenstehenden Formeln abgeschätzt werden. Hiermit können qualitative Verbesserungen der Aufbauarten erzielt werden. Die nachfolgende Formel [1] bezieht sich gemäß FIG 6 auf einen Leiter 9 und 10, der in keinem/nahezu keinem Feld eines anderen Leiters liegt. Die Formel [2] bezieht sich gemäß FIG 7 auf den Fall, dass sich zwei entgegengesetzt durchflossene Leiter gegenüberstehen. Die jeweiligen geometrischen Abmessungen t, w, l der Leiter 9 und 10 bzw. deren Abstand h sind in den Figuren 6 und 7 eingezeichnet bzw. in den untenstehenden Formeln [1] und [2] verwendet.

$$L = 2 \times l \times \left[\ln\times\left(\frac{l}{t+w}\right) + 0{,}5\right] \times \frac{nH}{cm} \qquad [1]$$

$$L = \frac{2\times h}{w} \times l \times \frac{nH}{cm} \qquad [2]$$

Die Auswirkung der Kommutierungsinduktivität auf die Verluste in einer Halbbrücke können in FIG 8 betrachtet werden. Dort ist der Leistungsverlust P$_v$ über der Streuinduktivität L dargestellt. Zu höheren Streuinduktivitäten hin steigt der Leistungsverlust P$_v$ stetig an. Gerade bei höheren Schaltfrequenzen und Strömen ist dieser Effekt der Hauptverlustanteil in dieser Halbbrückenkonfiguration erkennbar. Hierzu sei auf die folgenden Quellen hingewiesen:

[1] Power Supply Design Seminar 2004/2005, TI [überarbeitet Juni 2016], verfügbar unter: http://www.ti.com/lit/ml/slup224/slup224.pdf

[2] Efficient Power Conversion Corporation "EPC2015 - Enhancement-mode Power Transistor", EPC2015 datasheet, März 2011 [überarbeitet Juni 2016], verfügbar bei : http://www.epc-co.com/epc/DesignSupport/Application-Notes/AN003-UsingEnhancementMode.aspx

Die US 2014/183550 A1 beschreibt ein Layout einer Leiterplattenanordnung für einen elektrischen Umrichter, welches eine Selbstauslöschung des Magnetfelds und eine Reduzierung der parasitären Induktivität der Leiterplattenanordnung unabhängig von deren Leiterplattendicke ermöglicht. Ein Leistungsstromkreis der Leiterplatte erstreckt sich durch aktive und passive Bauelemente auf der oberen Schicht der Leiterplatte, wobei Durchkontaktierungen den Leistungsstromkreis mit einem Rückführungspfad in einer inneren Schicht der Leiterplatte verbinden. Der magnetische Effekt des Abschnitts des Leistungsstromkreises auf der oberen Schicht wird reduziert, indem der Rückführungspfad der inneren Schicht direkt unter dem Leistungsstromkreis auf der oberen Schicht angeordnet wird.

Die US 5 036 160 A lehrt eine Rückwandplatine (bzw. eine Bus-Leiterplatine), welche weitere Platinen-Segmente, die alternierend und gegeneinander beabstandet an einer ersten und an einer zweiten Oberfläche der Rückwandplatine angeordnet sind, mittels Leitungsbus und über Verbinder elektrisch miteinander verbindet. Der Leitungsbus der Rückwandplatine weist eine erste und eine zweite elektrische Leitung auf, welche zu einem Leitungspaar verdrillt sind und somit eine verbesserte Übertragung insbesondere von höherfrequenten elektrischen Signalen ermöglicht.

Die US 5 357 050 A offenbart ein Verfahren zum Anordnen von elektrischen Leitungen (z.B. Leiterbahnen) auf einer mehrschichtigen Leiterplatte, mittels dem elektromagnetische Emissionen, die von den Leitungen abgestrahlt werden, unterdrückt werden. Die Leitungen werden im Betrieb mit einem Differenzsignal beaufschlagt, wobei die Leitungen als Signalpaarleitungen, aufweisend eine Signalleitung und eine Signal-Rückleitung, ausgebildet sind. Die Signalleitungen und die Signal-Rückleitungen der Signalpaarleitungen sind derart angeordnet, dass deren Signalleitungen immer Signal-Rückleitungen und deren Signal-Rückleitungen immer Signalleitungen abwechselnd gegenüberliegen. Dabei sind alle Signalleitungen leitend miteinander verbunden und alle Signal-Rückleitungen leitend miteinander verbunden. Die Symmetrie der Anordnung bewirkt, dass sich die von den Leitungen erzeugten elektromagnetischen Felder in einem beliebigen Abstand aufheben. Darüber hinaus führt das Variieren von Kombinationen von Leiterplatten-Schichten und/oder das Variieren von Parametern wie Abmessung, Abstand und dielektrischem Material des Leiterplattenaufbaus beispielsweise zu einer gewünschten Impedanz zur Anpassung an eine externe Verkabelung.

Die EP 0 400 885 A1 zeigt eine Platine mit elektrischen Leiterbahnen für eine elektrische Schaltung, wobei die elektrischen Leiterbahnen zur Verbindung von elektronischen Bauelementen teilweise auf einer ersten Seite und teilweise auf einer von der ersten Seite abgewandten zweiten Seite angeordnet, durch die Platine geführt und gegeneinander verdrillt sind.

Die Aufgabe der vorliegenden Erfindung besteht somit darin, eine Halbbrückenanordnung bereitzustellen, die unempfindlicher gegenüber Schaltereignissen ist.

Erfindungsgemäß wird diese Aufgabe durch eine Halbbrückenanordnung nach Anspruch 1 gelöst. Vorteilhafte Weiterbildungen der Erfindung ergeben sich aus den Unteransprüchen.

Entsprechend der vorliegenden Erfindung wird demnach eine Halbbrückenanordnung für einen Umrichter mit zwei Schaltelementen, einer Kondensatoreinrichtung und einer Leiterplatte, mit der die Schaltelemente und die Kondensatoreinrichtung zu einer Halbbrücke zusammen geschaltet sind, bereitgestellt. Die Halbbrückenanordnung kann grundsätzlich auch für andere Einsatzzwecke außerhalb von Umrichtern verwendet werden. Für die beiden Schaltelemente können IGBTs, aber auch andere Leistungsschalter eingesetzt werden. Die Kondensatoreinrichtung dient zum Speichern bzw. Zwischenspeichern von Energie und ist typischerweise als Zwischenkreiskondensator realisiert. Die Schaltelemente sind in üblicher Weise auf einer Leiterplatte angeordnet und zu einer Halbbrücke verbunden, die an die Kondensatoreinrichtung angeschlossen ist.

Die Leiterplatte weist mindestens vier Leiterbahnlagen auf. Dadurch wird die Möglichkeit eröffnet, dass bei einem Kommutierungsereignis innerhalb der Leiterplatte Stromschleifen gebildet werden, die senkrecht zu den Hauptausdehnungsflächen der Leiterplatte ausgebildet sind. Bei einem Kommutierungsereignis, bei dem sich die Schaltstellung eines oder beider Schaltelemente ändert, entsteht mindestens ein Kommutierungskreis, dessen parasitäre Induktivität für das Schaltverhalten der Halbbrückenanordnung von Bedeutung ist. In vorteilhafter Weise sind nun die Schaltelemente sowie die Kondensatoreinrichtung an der Leiterplatte so angeordnet und mittels der Leiterbahnlagen so verschaltet, dass sich bei einem Kommutierungsereignis in der Leiterplatte mindestens zwei entgegengesetzte gerichtete Dipole ergeben. Es ergeben sich dabei also zwei parallele Kommutierungskreise, deren jeweilige Ströme entgegengesetzt gerichtete Dipole hervorrufen. Dadurch, dass die Dipole entgegengesetzt gerichtet sind, schwächt sich ihre Wirkung gegenseitig, woraus eine Verbesserung des Schaltverhaltens der Halbbrückenanordnung resultiert.

Vorzugsweise besitzt die Halbbrückeneinrichtung zwei Kondensatoren oder eine andere gerade Anzahl an Kondensatoren, die an der Leiterplatte symmetrisch angeordnet sind. Durch eine derartige symmetrische Anordnung lassen sich entsprechend gleichdimensionierte entgegengesetzt gerichtete Dipole bei einem Kommutierungsereignis, d.h. bei einer Kommutierung, erzeugen.

Darüber hinaus können die Schaltelemente und die Kondensatoren auf beiden Seiten der Leiterplatte angeordnet sein. Dies hat den Vorteil, dass beispielsweise eine punktsymmetrische Anordnung der Bauelemente erreicht werden kann. Bei einer solchen Anordnung kann gleichzeitig ausreichend Kühlfläche auf beiden Seiten der Leiterplatte bereitgestellt werden.

Die Schaltelemente sowie die Kondensatoreinrichtung können ferner so angeordnet und verschaltet sein, dass sich bei dem Kommutierungsereignis jeweils zwei entgegensetz gerichtete Dipole in zwei unterschiedlichen Raumrichtungen ergeben. Es wird für den Aufbau der Halbbrückenanordnung also nicht nur eine einzige Raumrichtung für die Dipole ausgenutzt, sondern mindestens zwei verschiedene Raumrichtungen, die voneinander abweichen und nicht parallel sind. Bei den jeweiligen entgegengesetzten Dipolen ist dann einer der Dipole mit der Raumrichtung gleichgerichtet und der andere Dipol entgegengesetzt zu dieser Raumrichtung ausgerichtet. Das gleiche gilt für die mindestens eine andere Raumrichtung.

In einer speziellen Ausgestaltung kann die Leiterplatte vier Leiterbahnlagen aufweisen, und bei dem Kommutierungsereignis treten mindestens vier parallele Kommutierungskreise auf. Ziel ist es, dass die gesamte parasitäre Induktivität der Halbbrückenanordnung möglichst gering ist. Da die Kommutierungskreise zueinander parallel geschaltet sind, ist es vorteilhaft, wenn mindestens einer der Kommutierungskreise eine sehr geringe Induktivität besitzt. Die resultierende Gesamtinduktivität ist dann kleiner als die kleinste Einzelinduktivität. Diesem Ziel kann leichter nachgekommen werden, je mehr Kommutierungskreise zur Verfügung stehen. So kann auch eine Halbbrückenanordnung realisiert werden, deren Leiterplatte mehr als vier Leiterbahnlagen aufweist, sodass sich mehr als vier Kommutierungskreise ergeben können.

Vorzugsweise sind die Kommutierungskreise symmetrisch zueinander angeordnet. Dadurch lässt sich ggf. erreichen, dass sich die Kommutierungsströme gegenseitig aufheben, was eine verminderte Störemission zur Folge hat.

In einer weiteren Ausgestaltung weist die Halbbrückenanordnung eine Treibereinrichtung auf, die so angeordnet ist, dass eine Treiberstromrichtung eines Hauptstroms der Treibereinrichtung senkrecht zu einer Kommutierungsstromrichtung eines Hauptstroms im Kommutierungskreis bei dem Kommutierungsereignis steht. Dadurch kann verhindert werden, dass der Treiberkreis bzw. die Treibereinrichtung leicht in den Kommutierungskreis bzw. die Schaltelemente des Kommutierungskreises einkoppelt und das Schaltverhalten der Halbbrückenanordnung verändert. Durch die senkrechte Anordnung der Treiberstromrichtung und der Kommutierungsstromrichtung kann vielmehr erreicht werden, dass sich die Ströme der betroffenen Kreise kaum beeinflussen.

In einer weiteren vorteilhaften Ausgestaltung ist ein Mittelabgang der Halbbrücke möglichst klein, insbesondere kleiner als fünf Prozent der Leiterplatte ausgebildet. Der Mittelabgang der Halbbrücke liefert klassischer Weise eine Wechselspannung. Wenn der Mittelabgang daher möglichst klein ausgebildet ist, erhöht sich die Störfestigkeit der gesamten Halbbrückenanordnung, da sich eine verminderte Kopplung zu anderen Bauelementen bzw. Bauteilen ergibt.

Des Weitern können die Leiterbahnlagen jeweils einen möglichst hohen Kupferfüllgrad besitzen. Dadurch ergeben sich Vorteile hinsichtlich der Entwärmung der Halbbrückenanordnung. Es wird nämlich dann nicht nur das Leiterplattensubstrat, sondern insbesondere das Kupfer zur Entwärmung genutzt, wobei letzteres einen sehr hohen Wärmeleitkoeffizienten besitzt.

In einer besonderen Anwendung wird ein Umrichter mit der oben genannten Halbbrückenanordnung ausgestattet. Bei den Umrichtern treten die Kommutierungsereignisse ständig auf, weshalb gerade dort die besondere Notwendigkeit besteht, das Schaltverhalten möglichst nicht durch parasitäre Induktivitäten beeinflussen zu lassen.

Die vorliegende Erfindung wird nun anhand der beigefügten Zeichnungen näher erläutert, in denen zeigen:

FIG 1      einen Schaltplan einer Halbbrücke mit Ansteuerung gemäß dem Stand der Technik;

FIG 2      eine prinzipielle Querschnittsansicht eines Halbbrückenmoduls mit einem Ansteuerkreis gemäß dem Stand der Technik;

FIG 3      den Querschnitt von FIG 2 mit einem Kommutierungskreis;

FIG 4      eine Skizze der Ansteuerung und des Kommutierungskreises bei einseitiger Bestückung gemäß dem Stand der Technik;

FIG 5      einen Querschnitt durch eine beidseitig bestückte Platine mit Kommutierungskreis gemäß dem Stand der Technik;

FIG 6      eine Skizze einer einzelnen Leiterbahn zur Berechnung der Streuinduktivität;

FIG 7      eine Skizze zweier paralleler Leiterbahnen zur Berechnung der Streuinduktivität;

FIG 8      Effekte der Verluste durch eine Kommutierungsinduktivität gemäß dem Stand der Technik;

FIG 9      mehrere Lagen von Leiterbahnen einer Leiterplatte für eine erfindungsgemäße Halbbrückenanordnung;

FIG 10      einen Querschnitt durch eine Ansteuerschaltung;

FIG 11      einen Querschnitt durch eine Leiterplatte entlang der Schaltelemente mit einem ersten Kommutierungskreis;

FIG 12      den Querschnitt von FIG 11 mit einem zweiten Kommutierungskreis;

FIG 13      den Querschnitt von FIG 11 mit einem dritten Kommutierungskreis und

FIG 14    den Querschnitt von FIG 11 mit einem vierten Kommutierungskreis.

Die nachfolgend näher geschilderte Ausführungsbeispiele stellen bevorzugte Ausführungsformen der vorliegenden Erfindung dar. Dabei ist zu beachten, dass die einzelnen Merkmale nicht nur in den geschilderten Merkmalskombinationen, sondern auch in Alleinstellung oder in anderen technisch sinnvollen Kombination realisiert werden können.

Die Beispiele beziehen sich auf eine Halbbrückenanordnung, die vorzugsweise in einem Umrichter eingesetzt wird. Die einzelnen Bauelemente und Bauteile sind entsprechend den gewünschten Leistungen auszulegen.

Besonderer Augenmerk wird auf die Anordnung der Komponenten und den Aufbau der Platine bzw. Leiterplatte 8 gerichtet. Zu den Komponenten zählen hier insbesondere diejenigen der Halbbrücke selbst einschließlich der Treiberkomponenten sowie die Komponente bzw. die Komponenten der Kondensatoreinrichtung.

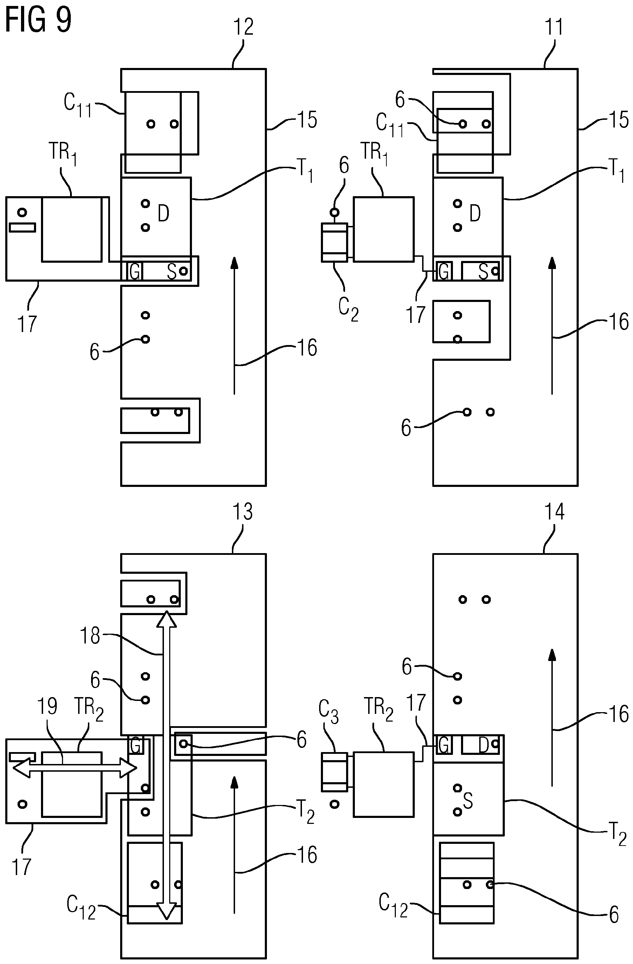

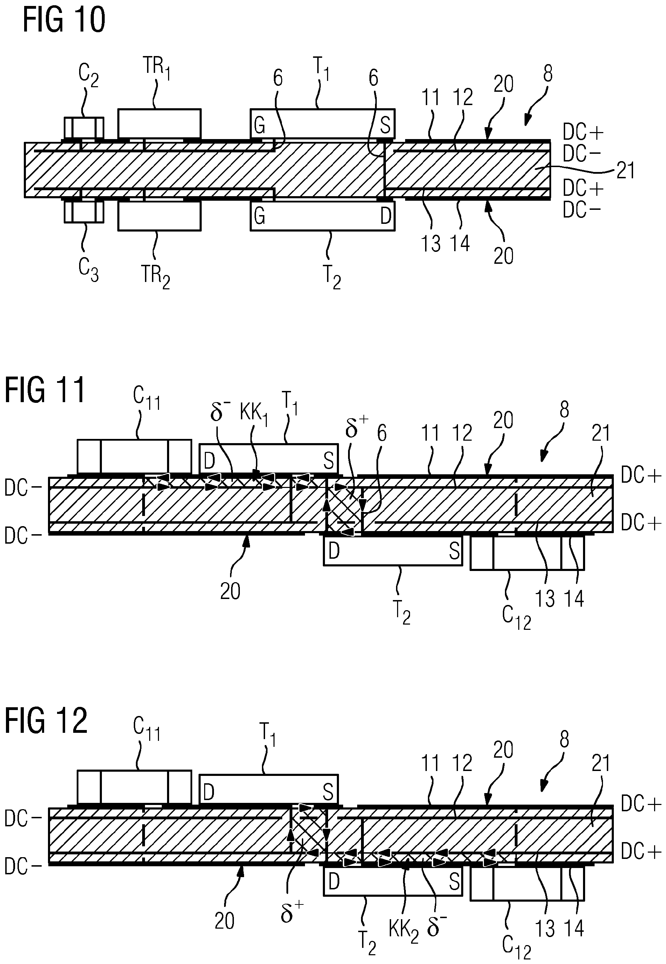

In FIG 9 sind vier Lagen 11, 12, 13 und 14 einer exemplarischen Leiterplatte dargestellt. Jede Lage stellt eine entsprechende Leiter- bzw. Kupferschicht dar. Beispielsweise wird die erste Lage 11 und die dritte Lage 13 auf positives Potenzial DC+ und die zweite Lage 12 sowie die vierte Lage 14 auf negatives Potenzial DC- gelegt. Zusätzlich zu den Leiterbahnlagen 11 bis 14 sind in FIG 9 auch die den Leiterbahnlagen unmittelbar zugeordneten Bauelemente und Durchkontaktierungen bzw. Verbinder 6 eingezeichnet. Durch die Übereinander-stapelung der einzelnen Lagen 11 bis 14 ergibt sich eine Leiterplatten- bzw. Halbbrückenanordnung mit den Querschnitten gemäß FIG 10 und FIG 11.

Jede der vier Lagen 11 bis 14 besitzt einen Hauptabschnitt 15, der hier rechteckförmig ausgestaltet ist und dessen Längsrichtung 16 sich parallel zu der Ausrichtung der Hintereinanderanordnung der Schaltelemente $T_1$ und $T_2$ erstreckt. Dabei ist zu beachten, dass sich die Schaltelemente $T_1$ und $T_2$ auf unterschiedlichen Seiten der Leiterplatte 8 befinden. In dem vorliegenden Beispiel ist der Zwischenkreiskondensator durch zwei Kondensatoren $C_{11}$ und $C_{12}$ realisiert. Auch diese beiden Kondensatoren befinden sich auf unterschiedlichen Seiten der Leiterplatte 8 (vgl. FIG 11). In ihrer Anordnung befinden sich die beiden Kondensatoren $C_{11}$ und $C_{12}$ auf der gleichen Linie wie die Hintereinanderanordnung der Schaltelemente $T_1$ und $T_2$, d.h. parallel zu der Längsrichtung 16. Der Querschnitt durch die Leiterplattenanordnung gemäß den FIG 11 bis 14 verläuft parallel zu der Längsrichtung 16.

An einer Längsseite jedes Hauptabschnitts 15 jeder Lage 11 bis 14 befindet sich ein Treiberabschnitt 17. Dieser Treiberabschnitt 17 dient zur Kontaktierung der Elemente der jeweiligen Treiber- bzw. Ansteuerkreise $AK_1$ und $AK_2$ (vgl. FIG 1). So verbinden die Treiberabschnitte 17 der ersten Lage 11 und der zweiten Lage 12 den Treiber $TR_1$ und den Kondensator $C_2$ mit dem dazugehörigen Schaltelement $T_1$. In gleicher Weise verbinden die Treiberabschnitte 17 der dritten Lage 13 und der vierten Lage 14 den zweiten Treiber $TR_2$ und den Kondensator $C_3$ mit dem zweiten Schaltelement $T_2$. Weiterhin sind für die einzelnen Lagen die sogenannten "Pads" zum Kontaktieren der Schaltelemente $T_1$ und $T_2$ zu erkennen. Insbesondere sind die Pads für Drain D, Source S und Gate G der Schaltelemente $T_1$ und $T_2$ eingezeichnet.

In der dritten Lage 13 ist außerdem eine Kommutierungsstromrichtung 18 eingezeichnet, die parallel zu der Längsrichtung 16 verläuft. Entlang dieser Kommutierungsstromrichtung 18 verläuft der Kommutierungsstrom durch die Bauelemente $T_1$, $T_2$, $C_{11}$ und $C_{12}$. Durch den Doppelpfeil der Kommutierungsstromrichtung 18 ist angedeutet, dass der Kommutierungsstrom auch entgegen der Längsrichtung 16 verlaufen kann.

Senkrecht zu der Längsrichtung 16 ergibt sich eine Treiberstromrichtung 19. Eine Hauptstromrichtung des Treiberstroms entspricht also der Treiberstromrichtung 19. Wie wiederum der Doppelpfeil andeutet, kann der Treiberstrom in beide entgegengesetzte Richtungen verlaufen. Die Tatsache, dass die Treiberstromrichtung 19 und die Kommutierungsstromrichtung 18 senkrecht zueinander verlaufen, d.h. der Ansteuerpfad senkrecht zum Kommutierungspfad liegt, ist ein besonders hervorzuhebender Aspekt. Dadurch sind die Stromflüsse und somit auch deren H-Felder überwiegend orthogonal zueinander ausgerichtet, was dazu führt, dass sich diese wenig beeinflussen. Somit erhöht sich die Störfestigkeit der Halbbrückenanordnung.

Wie oben erwähnt wurde, befindet sich ein Schaltelement $T_1$ mit Ansteuerung $TR_1$ und $C_2$ auf der einen Seite der Leiterplatte 8, z. B. der Oberseite und das andere Schaltelement $T_2$ mit Ansteuerung $TR_2$ und $C_3$ auf der anderen Seite, z. B. der Unterseite. Dadurch sind die Schaltelemente mit Treibern thermisch entkoppelt. Es kann eine Entwärmung über die jeweils freien Flächen 20 erfolgen (vgl. FIG 10 und 11). Die Spreizung der Wärme über der Fläche kann durch die Dicke der jeweiligen Kupferschicht und dem Kupferfüllgrad der Innenlagen vergrößert werden. Eine derartige Entwärmung ist in der Regel effizienter als die Entwärmung über das Substrat 21 der Leiterplatte 8. Hierbei ist die Verwendung eines Schaltelements mit einem "thermal-pad" am Drain-Anschluss zu bevorzugen. Dieses "thermal-pad" ist gegenüber den anderen Anschlüssen für Gate G und Source S größer ausgebildet. Ferner ist zu bevorzugen, wenn sich die Potenziale der einzelnen Lagen 11 bis 14 abwechseln, z. B. DC+, DC-, DC+, DC-.

In FIG 10 ist ein Querschnitt entlang der Treiberstromrichtung 19 durch die komplett montierte Leiterbahnanordnung bzw. Halbbrückenanordnung dargestellt. Die einzelnen Leiterbahnlagen 11 bis 14 sind übereinander angeordnet und bilden isoliert durch das Leiterplattensubstrat 21 die hier vierlagige Leiterplatte 8. Unmittelbar auf der ersten Leiterbahnlage 11 befinden sich die Bauelemente $T_1$, $TR_1$ und $C_2$ und unmittelbar auf der vierten Leiterbahnlage 14 befinden sich die Bauelemente $T_2$, $TR_2$ und $C_3$. Eine Durchkontaktierung bzw. ein Verbinder 6 verbindet Source S von Schalterelement $T_1$ mit Drain D von Schaltelement $T_2$. Weitere Verbinder 6 sind zwischen der ersten Leiterbahnlage 11 und der zweiten Leiterbahnlage 12 sowie zwischen der dritten Leiterbahnlage 13 und der vierten Leiterbahnlage 14 eingezeichnet.

Aus FIG 10 wird der besondere Aufbau der Ansteuerung von $T_1$ und $T_2$ sichtbar. Auf der jeweiligen Außenlage wird das Gate G verbunden und eine Lage darunter wieder zurückgeführt auf einem flächig ausgeführten unbelasteten Source-Anschluss des jeweiligen Schaltelements $T_1$ bzw. $T_2$. Durch diese Maßnahmen wird einerseits die Ansteuerinduktivität verringert, aber auch zusätzlich die Störfestigkeit erhöht.

In den FIG 11 bis 14 sind Querschnitte durch die Leiterplattenanordnung bzw. Halbbrückenanordnung parallel zu der Kommutierungsstromrichtung 18 bzw. der Längsrichtung 16 prinzipiell dargestellt. Insbesondere ist hier die Punktsymmetrie der Anordnung der einzelnen Bauelemente $T_1$, $T_2$, $C_{11}$ und $C_{12}$ zu erkennen. Durch diese Symmetrie ergeben sich spezielle Bedingungen im Hinblick auf die jeweiligen Kommutierungskreise. Diese Kommutierungskreise sind in den FIG 11 bis 14 beispielhaft dargestellt. Sie entstehen gleichzeitig bei einem Kommutierungsereignis, d.h. einer Änderung des Schaltzustands der Schaltelemente $T_1$ und/oder $TR_2$.

In FIG 11 ist ein erster Kommutierungskreis $KK_1$ eingezeichnet. Er beginnt in der ersten Leiterbahnlage 11 bei Kondensator $C_{11}$(ein Teil des Zwischenkreiskondensators $C_1$), verläuft über die zweite Lage 12 und einem Verbinder zu Source S von $T_2$ (vierte Lage 14), dann zu Drain D von $T_2$, weiter über einen Verbinder 6 zu Source S und Drain D von $T_1$ (erste Lage 11) und zurück zum anderen Anschluss von Kondensator $C_{11}$. Dabei ergeben sich für den Stromverlauf zwei Maschen, die entgegengesetzt gerichtet sind. Entsprechend resultieren daraus gemäß der "rechten-Hand-Regel" ein Dipol $\delta^+$ und ein entgegengesetzter Dipol $\delta^-$. Die beiden Dipole des ersten Kommutierungskreises $KK_1$ reduzieren sich also aufgrund ihrer entgegengesetzten Richtung in ihrer Wirkung.

Symmetrisch hierzu entsteht ein analoger Kommutierungskreis $KK_2$ durch das symmetrisch angeordnete zweite Schaltelement $T_2$ und den korrespondierenden Kondensator $C_{12}$ des Zwischenkreiskondensators $C_1$, wie dies in FIG 12 dargestellt ist. In gleicher Weise ergeben sich auch hier die entgegengesetzten Dipole $\delta^+$ und $\delta^-$.

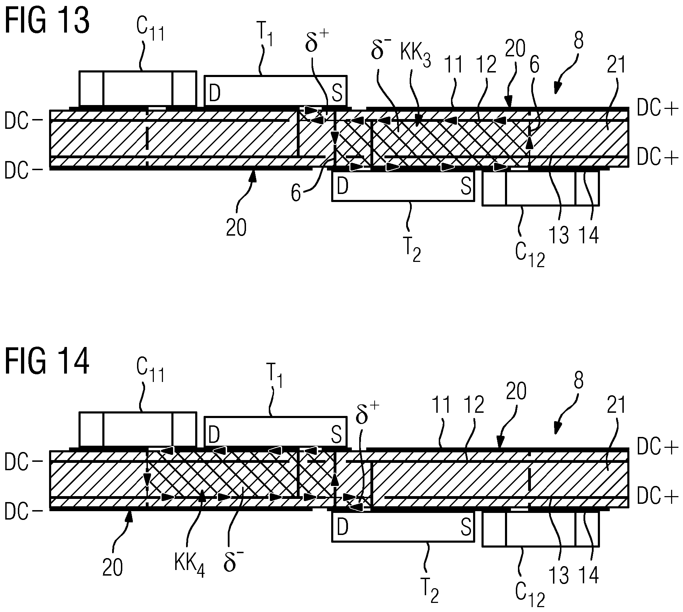

Ein dritter Kommutierungskreis $KK_3$ ergibt sich entsprechend der Darstellung von FIG 13. Der Kommutierungskreis verläuft hier von Drain D über Source S des Schaltelements $T_1$ (erste Lage 11) weiter zu Drain D und Source S des Schaltelements $T_2$ (vierte Lage 14), anschließend durch den Kondensator $C_{12}$ (vierte Leiterbahnlage 14) und zurück über die zweite Leiterbahnlage 12 zu Drain D des Schaltelements $T_1$. Durch die entsprechenden Maschenumläufe ergeben sich wieder die beiden entgegengesetzten Dipole $\delta^+$ und $\delta^-$.

Analog hierzu ergibt sich ein vierter Kommutierungskreis $KK_4$ gemäß FIG 14 aufgrund der symmetrischen Anordnung ausgehend von Source S über Drain D von $T_2$ und so weiter.

Durch die Nutzung der Innenlagen werden die Kommutierungspfade flächig aneinander vorbeigeführt, was deren Induktivität minimiert. Darüber hinaus werden, wie die FIG 11 bis 14 zeigen, parallele Kommutierungskreise $KK_1$ bis $KK_4$ aufgebaut, was zu einer Parallelschaltung der jeweiligen Induktivitäten führt und somit eine weitere Verkleinerung der Gesamtinduktivität bringt. Dabei kann das Konzept beliebig durch weitere Innenlagen erweitert werden, was zu einer weiteren Parallelschaltung und damit zu immer geringeren Induktivitäten im Kommutierungspfad führt.

Ein besonderes Augenmerk bei dieser Anordnung gilt der Symmetrie der Kommutierungspfade. Dadurch heben sich die Kommutierungsströme zusätzlich auf, und es ergibt sich eine geringe Störemission der gesamten Schaltung.

Ein weiterer Aspekt ergibt sich bzgl. der Abschirmung des Mittelabgangs (in FIG 9 in der dritten Lage 13 mit "AC" bezeichnet) der Halbbrücke. Dieser Mittelabgang schwingt im Bezug zu den "festen" Zwischenkreispotenzialen. Deshalb wird dieser möglichst klein ausgeführt, was zu einer kleineren parasitären Kapazität und somit zu weniger Störungen führt. Dabei ist hervorzuheben, dass der komplette Anschluss auf diese Weise optimal aus EMV-Sicht geschirmt ist (vgl. zweite Lage 12 darüber und vierte Lage 14 darunter).

Als Vorzugsanordnung für eine passive Entwärmung dieser Schaltung ist eine senkrechte Einbaulage zu empfehlen. Dadurch kann die Wärme auf beiden Seiten der Leiterplatte 8 abgeführt werden.

Der in dem Ausführungsbeispiel dargestellte Aufbau kann auch zur Parallelschaltung (besonders von GaN-on-Si-Schaltern) mehrerer Schalter mit einem Treiber genutzt werden. Dabei ist die thermische Kopplung zwischen den Schaltern besonders wichtig. So wird eine symmetrische Stromaufteilung zwischen den Schaltern erreicht.

Der besondere Vorzug der oben geschilderten Halbbrückenanordnung liegt in der spezifischen geometrischen Anordnung der Halbbrückenkomponenten. Durch den Einsatz einer Mehr-Layer-Platine und unter Berücksichtigung der Symmetrie entsteht ein sehr niederinduktiver Aufbau. Zusätzlich ist eine Lösung zur passiven Entwärmung auf der Leiterplatte gezeigt, wodurch keine zusätzliche Kühlung erforderlich ist. Ein weiterer positiver Aspekt liegt in dem optimierten EMV-Verhalten, welches besonders für schnellschaltende Bauelemente (GaN-on-Si oder Si-C) von enormer Wichtigkeit ist.

Es ergeben sich also insbesondere Vorteile aufgrund des niederinduktiven Aufbaus wegen der parallelen Kommutierungspfade. So kommt es zu kleineren Schaltüberspannungen und weniger Schaltverlusten. Außerdem sind höhere Schaltfrequenzen möglich, und die Induktivitäten können durch mehr Innenlagen weiter verringert werden.

Hinsichtlich der Störfestigkeit ist vorteilhaft zu erwähnen, dass weniger externe Beschaltung nötig ist, höhere Schaltgeschwindigkeiten und Schaltfrequenzen möglich sind und sich eine geringere EMV-Belastung ergibt. Letzteres resultiert insbesondere aus der Schirmung des Mittelabgriffs, einer Feldaufhebung von Kommutierungskreis und Ansteuerkreis (senkrechte Anordnung) und der Tatsache, dass sich die Felder der parallelen Kommutierungskreise auf-

heben (symmetrischer Aufbau).

Ein weiterer Vorteil besteht darin, dass die Induktivitäten unabhängig von der Platinen-Dicke sind. Insbesondere ergeben sich niedrige Induktivitäten auch bei hohen Kupferlagen, wenn die Bauelemente aufgrund der Rampenform an den Kupferrändern weiter auseinander rücken müssen. Schließlich ergibt sich bei der obigen Halbbrückenanordnung auch die Möglichkeit einer optimierten Entwärmung. Es kann nämlich eine verbesserte Wärmespreizung über die Leiterplatte sowie eine beidseitige Entwärmung erzielt werden.

**Patentansprüche**

1. Halbbrückenanordnung für einen Umrichter mit

   - zwei Schaltelementen ($T_1$, $T_2$),
   - einer Kondensatoreinrichtung ($C_1$, $C_{11}$, $C_{12}$) und
   - einer Leiterplatte (8), aufweisend mindestens vier Leiterbahnlagen, Durchkontaktierungen, eine Längsrichtung und eine Querrichtung, mit der die Schaltelemente und die Kondensatoreinrichtung zu einer Halbbrücke zusammengeschaltet sind, **dadurch gekennzeichnet, dass** die Schaltelemente in der Längsrichtung der Leiterplatte in einer Linie hintereinander und auf gegenüberliegenden Oberflächen der Leiterplatte in besagter Linie punktsymmetrisch zueinander angeordnet sind, und dass ein Stromverlauf eines Kommutierungsstroms durch die Schaltelemente, die Kondensatoreinrichtung, die Leiterbahnlagen und die Durchkontaktierungen zwei Maschen ergibt, die entgegengesetzt orientiert sind, wodurch sich entsprechend angeregte entgegengesetzt gerichtete magnetische Dipole ($\delta^+$, $\delta^-$) reduzieren.

2. Halbbrückenanordnung nach Anspruch 1, wobei die Kondensatoreinrichtung zwei Kondensatoren aufweist, die, zusammen mit den Schaltelementen, in der Längsrichtung der Leiterplatte in einer Linie hintereinander und auf gegenüberliegenden Oberflächen der Leiterplatte in besagter Linie punktsymmetrisch zueinander angeordnet sind.

3. Halbbrückenanordnung nach einem der vorhergehenden Ansprüche, wobei die Schaltelemente sowie die Kondensatoreinrichtung so angeordnet und verschaltet sind, dass sich bei dem Kommutierungsereignis jeweils zwei entgegengesetzt gerichtete Dipole ($\delta^+$, $\delta^-$) in zwei unterschiedlichen Raumrichtungen ergeben.

4. Halbbrückenanordnung nach einem der vorhergehenden Ansprüche, wobei die Leiterplatte (8) vier Leiterbahnlagen (11,12,13,14) aufweist und bei dem Kommutierungsereignis mindestens vier parallele Kommutierungskreise ($KK_1$, $KK_2$, $KK_3$, $KK_4$) auftreten.

5. Halbbrückenanordnung nach Anspruch 4, wobei die Kommutierungskreise ($KK_1$, $KK_2$, $KK_3$, $KK_4$) symmetrisch zueinander angeordnet sind.

6. Halbbrückenanordnung nach einem der vorhergehenden Ansprüche, die eine Treibereinrichtung ($TR_1$, $TR_2$) aufweist, die so angeordnet ist, dass eine Treiberstromrichtung (19) eines Hauptstroms der Treibereinrichtung senkrecht zu einer Kommutierungsstromrichtung (18) eines Hauptstroms bei dem Kommutierungsereignis steht.

7. Halbbrückenanordnung nach einem der vorhergehenden Ansprüche, wobei ein Mittelabgang der Halbbrücke möglichst klein, insbesondere kleiner als 5% der Fläche der Leiterplatte (18), ausgebildet ist.

8. Halbbrückenanordnung nach einem der vorhergehenden Ansprüche, wobei die Leiterbahnlagen (11,12,13,14) einen möglichst hohen Kupferfüllgrad besitzen.

9. Umrichter mit einer Halbbrückenanordnung nach einem der vorhergehenden Ansprüche.

**Claims**

1. Half-bridge arrangement for a converter, comprising

   - two switching elements ($T_1$, $T_2$),
   - a capacitor device ($C_1$, $C_{11}$, $C_{12}$) and
   - a circuit board (8), having at least four trace layers, via holes, a longitudinal direction and a transverse direction, to which the switching elements and the capacitor device are interconnected to form a half bridge,

**characterised in that**
the switching elements are arranged in series in a line in the longitudinal direction of the circuit board and with point symmetry with respect to one another on opposite surfaces of the circuit board in said line, and that a current profile of a commutation current through the switching elements, the capacitor device, the trace layers and the via holes produces two meshes, which are oriented opposite one another, whereby accordingly excited magnetic dipoles ($\delta^+$, $\delta^-$) of opposite direction are reduced.

2. Half-bridge arrangement according to claim 1, wherein the capacitor device has two capacitors, which together with the switching elements are arranged in series in a line in the longitudinal direction of the circuit board and with point symmetry with respect to one another on opposite surfaces of the circuit board in said line.

3. Half-bridge arrangement according to one of the preceding claims, wherein the switching elements and the capacitor device are disposed and interconnected such that, during a commutation event, two dipoles ($\delta^+$, $\delta^-$). Of opposite direction are produced in two different spatial directions.

4. Half-bridge arrangement according to one of the preceding claims, wherein the circuit board (8) has four trace layers (11,12,13,14) and at least four parallel commutation circuits ($KK_1$, $KK_2$, $KK_3$, $KK_4$) occur during the commutation event.

5. Half-bridge arrangement according to claim 4, wherein the commutation circuits ($KK_1$, $KK_2$, $KK_3$, $KK_4$) are disposed symmetrically with respect to one another.

6. Half-bridge arrangement according to one of the preceding claims, comprising a driver device ($TR_1$, $TR_2$) which is disposed such that a driver current direction (19) of a main current of the driver device is perpendicular to a commutation current direction (18) of a main current during the commutation event.

7. Half-bridge arrangement according to one of the preceding claims, wherein a centre tap of the half bridge is made as small as possible, in particular smaller than 5% of the surface area of the circuit board (18).

8. Half-bridge arrangement according to one of the preceding claims, wherein the circuit trace layers (11,12,13,14) have a maximally high copper fill factor.

9. Converter comprising a half-bridge arrangement according to one of the preceding claims.

**Revendications**

1. Système à demi-pont pour un onduleur, comprenant

   - deux éléments ($T_1$, $T_2$) de coupure,
   - un dispositif ($C_1$, $C_{11}$, $C_{12}$) à condensateur et
   - une plaquette (8) à circuit imprimé, ayant au moins quatre couches de piste conductrice, des trous traversants, une direction longitudinale et une direction transversale, par lequel les éléments de coupure et le dispositif de condensateur sont rassemblés en un demi-pont,

   **caractérisé en ce que**
   les éléments de coupure sont montés l'un derrière l'autre en une ligne dans la direction longitudinale de la plaquette à circuit imprimé et sont montés en étant symétriques par rapport à un point dans ladite ligne, sur des surfaces opposées de la plaquette à circuit imprimé et **en ce qu'**une courbe d'un courant de commutation dans les éléments de coupure, le dispositif de condensation, les couches de piste conductrice et les trous traversants donnent deux mailles, qui sont orientées en sens contraire, grâce à quoi des dipôles ($\delta^+$,$\delta^-$) magnétiques excités en conséquence et de sens opposé sont réduits.

2. Système à demi-pont suivant la revendication 1, dans lequel le dispositif de condensateur a deux condensateurs, qui, ensemble avec les éléments de coupure, sont montés dans la direction longitudinale de la plaquette à circuit imprimé l'un derrière l'autre suivant une ligne et sont montés en étant symétriques par rapport à un point dans ladite ligne, sur des surfaces opposées de la plaquette à circuit imprimé.

3. Système à demi-pont suivant l'une des revendications précédentes, dans lequel les éléments de coupure ainsi que le dispositif de condensateur sont disposés et connectés de manière à donner, à la commutation, respectivement, deux dipôles ($\delta^+$, $\delta^-$) dirigés en sens opposé dans deux directions différentes de l'espace.

4. Système à demi-pont suivant l'une des revendications précédentes, dans lequel la plaquette (8) à circuit imprimé a quatre couches (11, 12, 13, 14) de piste conductrice et, à la commutation, il se produit au moins quatre circuits ($KK_1$, $KK_2$, $KK_3$, $KK_4$) parallèles de commutation.

5. Système à demi-pont suivant la revendication 4, dans lequel les circuits (KK1, KK2, KK, KK4) de commutation sont disposés de manière symétrique les uns par rapport aux autres.

6. Système à demi-pont suivant l'une des revendications précédentes, qui a un dispositif (TR1, TR2) d'attaque, monté de manière à ce qu'une direction (19) de courant d'attaque d'un courant principal du dispositif d'attaque soit perpendiculaire à une direction (18) de courant de commutation d'un courant principal à la commutation.

7. Système à demi-pont suivant l'une des revendications précédentes, dans lequel une sortie médiane du demi-pont est aussi petite que possible, en représentant notamment moins que 5% de la surface de la plaquette (18) à circuit imprimé.

8. Système à demi-pont suivant l'une des revendications précédentes, dans lequel les couches (11, 12, 13, 14) de piste conductrice ont un degré de remplissage de cuivre aussi grand que possible.

9. Onduleur ayant un système en demi-pont suivant l'une des revendications précédentes.

# FIG 1
(Stand der Technik)

KK

DC+

$C_2$   $Vcc_1$   $T_1$

$TR_1$   D
G
S

$C_1$   $AK_1$

1   AC

$C_3$   $Vcc_2$   $T_2$

$TR_2$   D
G
S

$AK_2$

DC−

## FIG 2
(Stand der Technik)

## FIG 3
(Stand der Technik)

## FIG 4
(Stand der Technik)

## FIG 5
(Stand der Technik)

## FIG 6
(Stand der Technik)

## FIG 7
(Stand der Technik)

## FIG 8
(Stand der Technik)

FIG 9

# FIG 10

# FIG 11

# FIG 12

FIG 13

$C_{11}$    $T_1$    $\delta^+$    $\delta^-$ $KK_3$   11   12   20   6   8    21

D    S

DC−

DC−

DC+

DC+

6

20

D    S

$T_2$    $C_{12}$    13 14

FIG 14

$C_{11}$    $T_1$    $\delta^+$    11   12   20    8    21

D    S

DC−

DC−

DC+

DC+

20    $KK_4$   $\delta^-$

D    S

$T_2$    $C_{12}$    13 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2014183550 A1
- US 5036160 A
- US 5357050 A
- EP 0400885 A1

**In der Beschreibung aufgeführte Nicht-Patentliteratur**

- *Power Supply Design Seminar 2004/2005,* Juni 2016, http://www.ti.com/lit/ml/slup224/slup224.pdf
- EPC2015 - Enhancement-mode Power Transistor. *Efficient Power Conversion Corporation,* Marz 2011, http://www.epc-co.com/epc/DesignSupport/ApplicationNotes/AN003-UsingEnhancementMode.aspx